# EUROPEAN PATENT APPLICATION

(11) **EP 4 518 119 A1**
(43) Date of publication of application: **05.03.2025**
(21) Application number: 23902051.4
(22) Date of filing: 15.06.2023
(51) Int. Cl.: H02M 1/00, H02M 1/32, H02M 7/48, H05K 7/14, H05K 7/20

(54) **POWER CONVERTER**

(30) Priority: 16.12.2022 CN 202223416260 U
(71) Applicant: Huawei Digital Power Technologies Co., Ltd., Shenzhen, Guangdong 518043 (CN)
(72) Inventor: ZHANG, Zhixiang, Shenzhen, Guangdong 518043 (CN); LI, Luo, Shenzhen, Guangdong 518043 (CN); LI, Maofan, Shenzhen, Guangdong 518043 (CN)
(74) Representative: Gill Jennings & Every LLP
(86) International application number: PCT/CN2023/100545
(87) International publication number: WO 2024/124839

(57) **Abstract**

Embodiments of this application provide a power converter. The power converter includes a housing, a circuit board, a heat sink, at least one power semiconductor device, at least one thermally conductive insulating substrate, and at least two limiting structures. The housing includes an accommodation cavity and a through opening, and the through opening is in communication with the accommodation cavity. The heat sink is located at the through opening and outside the accommodation cavity, and is fixedly connected to the housing. The at least one insulating substrate is located in the through opening and is fixedly mounted on a surface that is of the heat sink and that faces the through opening, and each insulating substrate corresponds to at least two limiting structures. The at least one power semiconductor device is fixedly mounted on a surface that is of each insulating substrate and that is opposite to the heat sink, and each power semiconductor device is electrically connected to the circuit board. The circuit board is fixedly mounted in the accommodation cavity and is higher than the power semiconductor device in a height direction of the power converter. In this way, production efficiency of the heat sink can be improved, and production efficiency of the power converter can be improved.

## Description

This application claims priority to Chinese Patent Application No. 202223416260.6, filed with the China National Intellectual Property Administration on December 16, 2022 and entitled "POWER CONVERTER", which is incorporated herein by reference in its entirety.

### TECHNICAL FIELD

Embodiments of this application relate to the field of power converter technologies, and in particular, to a power converter.

### BACKGROUND

Power converters are used in communication, automotive electronics, power grids, new energy vehicles, and other fields. The power converter is an apparatus that can convert a specific type of current into another type of current. The power converter generates heat when working. If the heat cannot be dissipated in time, a temperature of the power converter increases and performance of the power converter is affected.

In a conventional technology, a power converter dissipates heat of a power semiconductor device by using the power converter including a heat sink and a ceramic substrate. The ceramic substrate is located between the power semiconductor device and the heat sink, and the ceramic substrate is in close contact with the power semiconductor device and the heat sink separately. The heat generated by the power semiconductor device is transferred to the heat sink through the ceramic substrate to ensure that a temperature of the power semiconductor device is within a reasonable temperature range.

However, an existing power converter has low production efficiency.

### SUMMARY

Embodiments of this application provide a power converter, so as to resolve a problem of low production efficiency of an existing power converter.

A first aspect of this application provides a power converter, including a housing, a circuit board, a heat sink, at least one power semiconductor device, at least one thermally conductive insulating substrate, and at least two limiting structures. The housing includes an accommodation cavity and a through opening, and the through opening is in communication with the accommodation cavity. The heat sink is located at the through opening and outside the accommodation cavity, and the heat sink is fixedly connected to the housing. The at least one insulating substrate is located in the through opening and is fixedly mounted on a surface that is of the heat sink and that faces the through opening, and each insulating substrate corresponds to at least two limiting structures. The at least one power semiconductor device is fixedly mounted on a surface that is of each insulating substrate and that is opposite to the heat sink, and the at least one power semiconductor device is electrically connected to the circuit board. The circuit board is fixedly mounted in the accommodation cavity, and is higher than the power semiconductor device in a height direction of the power converter. Each limiting structure includes a fitting part and a fixing part that cooperates with the fitting part. The fitting part is disposed on the insulating substrate, and the fixing part is disposed on a surface on which the heat sink is in contact with the insulating substrate.

Each insulating substrate of the power converter in this embodiment of this application cooperates with the heat sink by using the at least two limiting structures, and the insulating substrate may be fastened to a corresponding position on a surface of the heat sink, so that the insulating substrate does not horizontally move on the surface of the heat sink, and does not rotate on the surface of the heat sink. Therefore, the limiting structure can effectively fasten the insulating substrate and ensure that the insulating substrate does not move on the surface of the heat sink. The limiting structure is used to limit movement of the insulating substrate in a horizontal direction, and a large-area groove for inserting the insulating substrate does not need to be disposed on the heat sink. Therefore, a groove milling process can be removed in a processing process of the heat sink, further, processing efficiency of the heat sink can be improved, and production efficiency of the power converter can be improved.

In a possible implementation, each fixing part is a fixing post, and a connection end of the fixing post is fixedly connected to the heat sink. Each fitting part is a fitting hole that penetrates the insulating substrate, and the fitting hole is used for inserting the fixing post. Inserting the fixing post into the fitting hole can ensure that the insulating substrate cannot move on the surface of the heat sink. In addition, the production efficiency of the power converter can be improved.

In a possible implementation, each fixing part is a fixing post, and a connection end of the fixing post is fixedly connected to the heat sink. Each fitting part is a fitting notch that penetrates the insulating substrate, and the fitting notch is used for inserting the fixing post. The insulating substrate may be fastened on the surface of the heat sink by clamping the fixing post into the fitting notch, so as to ensure that the insulating substrate does not horizontally move or rotate on the surface of the heat sink. In addition, the production efficiency of the power converter can be improved.

In a possible implementation, at least two fixing parts corresponding to each insulating substrate are fixing posts, and a connection end of each fixing post is fixedly connected to the heat sink. At least one fitting part corresponding to each insulating substrate is a fitting hole for inserting the fixing post, and the at least one fitting part corresponding to each insulating substrate is a fitting notch for inserting the fixing post. A quantity of the fixing posts corresponding to each insulating substrate is equal to a sum of quantities of fitting holes and fitting notches that correspond to the insulating substrate. The insulating substrate may be fastened on the surface of the heat sink by inserting the fixing post into the fitting hole or the fitting notch, so as to ensure that the insulating substrate does not horizontally move or rotate on the surface of the heat sink.

In a possible implementation, each fixing part is a fixing hole located on the surface that is of the heat sink and that faces the through opening. Each fitting part is a fitting protrusion for inserting into a corresponding fixing hole, and a connection end of the fitting protrusion is fixedly connected to the insulating substrate. The insulating substrate may be fastened on the surface of the heat sink by clamping the fitting protrusion into the fixing hole, so as to ensure that the insulating substrate does not horizontally move or rotate on the surface of the heat sink. In addition, the production efficiency of the power converter can be improved.

In a possible implementation, at least two fitting parts on each insulating substrate are disposed at intervals along a circumferential direction of the insulating substrate. Altematively, at least two fitting parts on each insulating substrate are located on a same side of the insulating substrate. In this way, a quantity of limiting structures corresponding to each insulating substrate is reduced, and the processing efficiency of the heat sink is improved.

In a possible implementation, at least two fixing parts corresponding to each insulating substrate are disposed at intervals along a circumferential direction of the insulating substrate. Each fixing part includes a fixing structure that cooperates with a part of the insulating substrate, and a part that is of the insulating substrate and that cooperates with the fixing structure is used as the fitting part. In this way, the insulating substrate may be fastened on the surface of the heat sink, so as to ensure that the insulating substrate does not horizontally move or rotate on the surface of the heat sink.

In a possible implementation, each fixing part includes two fixing protrusions disposed at intervals, a connection end of the fixing protrusions is fixedly connected to the heat sink, and the two fixing protrusions and the surface of the heat sink jointly define a fixing notch. The part of the insulating substrate is inserted into the fixing notch and is in contact with the two fixing protrusions separately. Because the part of the insulating substrate extends into the fixing notch, the insulating substrate can be clamped, and the insulating substrate cannot move on the surface of the heat sink.

In a possible implementation, a side wall that is of each fixing part and that faces the insulating substrate defines a fixing groove. The part of the insulating substrate is inserted into the fixing groove and is in contact with an inner wall of the fixing groove. Because a part of the insulating substrate extends into the fixing groove, the insulating substrate can be clamped, and the insulating substrate cannot move on the surface of the heat sink.

In a possible implementation, the insulating substrate is a ceramic substrate, which may transfer heat generated by the power semiconductor device to the heat sink, and may further prevent a current of the power semiconductor device from being transferred to the heat sink through the insulating substrate.

In a possible implementation, the heat sink includes a metal body part and a plurality of plate-shaped parts. The metal body part is close to the through opening and is fixedly connected to the heat sink, and the insulating substrate is fixedly mounted on a surface that is of the metal body part and that faces the through opening. The plurality of plate-shaped parts are fixedly connected to the metal body part and are located on a surface that is of the metal body part and that is opposite to the insulating substrate, and the plurality of plate-shaped parts are disposed at intervals along a length direction of the metal body part. In this way, a heat exchange area between the heat sink and the air can be increased, and a heat dissipation capability of the heat sink can be improved.

In a possible implementation, the power converter further includes a pressing member. A first end of the pressing member is fixedly connected to a surface end that is of the heat sink and that faces the through opening, a second end of the pressing member abuts against the power semiconductor device, and the pressing member is configured to fasten the power semiconductor device and the insulating substrate to the heat sink. It can be ensured that the power semiconductor device is in close contact with the insulating substrate and the heat sink separately by using the pressing member, and this helps to improve a heat dissipation capability of the power semiconductor device.

In a possible implementation, a third end of the pressing member is fixedly connected to the circuit board, and the circuit board is fastened to the housing by using the pressing member and the heat sink. Relative positions of the circuit board and the power semiconductor device are ensured by using the pressing member, so that an application range of the pressing member can be improved, and structure complexity of the power converter can be reduced.

A second aspect of this application provides an electronic device, and the electronic device includes at least the power converter according to the second aspect. The power converter is included, so that production efficiency of the power converter is improved because the power converter has high production efficiency.

### BRIEF DESCRIPTION OF DRAWINGS

FIG. 1 is a diagram of a three-dimensional structure of a power converter in a conventional technology;
FIG. 2 is an exploded view of a first power converter according to an embodiment of this application;
FIG. 3 is a sectional view of the power converter according to the embodiment shown in FIG. 2;
FIG. 4 is a partial enlarged view at an insulating substrate in FIG. 3;
FIG. 5 is a partial sectional view of the first power converter after a housing is removed according to the embodiment shown in FIG. 2;
FIG. 6 is a diagram of a partial structure of cooperation between a heat sink and a first insulating substrate according to the embodiment shown in FIG. 2;
FIG. 7 is a partial schematic diagram of the cooperation between the heat sink and the first insulating substrate according to the embodiment shown in FIG. 6;
FIG. 8 is a schematic diagram of a second insulating substrate according to an embodiment of this application;
FIG. 9 is a diagram of a partial structure of a second power converter including a third insulating substrate according to an embodiment of this application;
FIG. 10 is a schematic diagram of a fourth insulating substrate according to an embodiment of this application;
FIG. 11 is a schematic diagram of a fifth insulating substrate according to an embodiment of this application;
FIG. 12 is a diagram of a partial structure of a third power converter including a sixth insulating substrate according to an embodiment of this application;
FIG. 13 is a schematic diagram of a seventh insulating substrate according to an embodiment of this application;
FIG. 14 is a diagram of a partial structure of a fourth power converter including an eighth insulating substrate according to an embodiment of this application;
FIG. 15 is a partial sectional view of cooperation between a heat sink and the insulating substrate according to the embodiment shown in FIG. 11;
FIG. 16 is a bottom view of a ninth insulating substrate according to an embodiment of this application;
FIG. 17 is diagram of a partial structure of a fifth power converter including a fixing notch according to an embodiment of this application;
FIG. 18 is a schematic diagram in which a fixing protrusion is a long strip boss according to an embodiment of this application;
FIG. 19 is a diagram of a partial structure of a sixth power converter including four fixing notches according to an embodiment of this application;
FIG. 20 is a diagram of a partial structure of a seventh power converter including two fixing grooves according to an embodiment of this application;
FIG. 21 is a diagram of a partial structure of an eighth power converter including a fixing groove according to an embodiment of this application; and
FIG. 22 is a schematic diagram of a structure of a ninth power converter including six limiting structures according to an embodiment of this application.

Descriptions of reference numerals:
10. heat sink; 11. metal body part; 12. plate-shaped part;
20. insulating substrate;
30. power semiconductor device;
40. fixing part; 41. fixing post; 42. fixing hole; 43. fixing protrusion; 44. fixing notch; 45. fixing groove;
50. fitting part; 51. fitting hole; 52. fitting notch; 53. fitting protrusion;
60. pressing member;
70. housing; 71. accommodation cavity; 72. through opening; 73. cover plate; 74. bottom housing;
80. circuit board; and
100. power converter.

### DESCRIPTION OF EMBODIMENTS

Terms used in embodiments of this application are only used to explain specific embodiments of this application, but are not intended to limit this application.

An electronic device provided in embodiments of this application may include but is not limited to a device that needs to perform power conversion, such as a photovoltaic device, a server power supply, an uninterruptible power supply, an electric vehicle charging pile, a power generation system, and an electric vehicle.

In embodiments of this application, an example in which the photovoltaic device is the electronic device is used for description.

The photovoltaic device provided in embodiments of this application may include a photovoltaic module, an inverter, and a power distribution cabinet. The photovoltaic module is configured to convert solar energy into direct current electric energy. The inverter is configured to convert the direct current electric energy generated by the photovoltaic module into alternating current electric energy. The power distribution cabinet is configured to distribute the alternating current electric energy output from the inverter to connect to a power grid or load.

The inverter may include a single board, a power semiconductor device, and a cabinet. The cabinet specifically includes a cavity for accommodating the power semiconductor device and the single board. The single board is fixedly connected to the cabinet and is electrically connected to the power semiconductor device.

The power semiconductor device, also known as a power electronic device, is a high-power electronic device configured to realize electric energy conversion and circuit control. The power semiconductor device may be an insulated gate bipolar transistor (Insulated Gate Bipolar Transistor, IGBT for short), a power field effect transistor (Metal Oxide Semiconductor FET, Power MOSFET for short), a gate-tum-off thyristor (Gate-Turn-Off Thyristor, GTO for short), and the like.

The power semiconductor device generates heat in a working process. If the heat cannot be released in time, a temperature of the power semiconductor device is excessively high, which affects use of the power semiconductor device, and even reduces a service life of the power semiconductor device.

Therefore, the inverter may further include a heat dissipation component, and the heat dissipation component is configured to dissipate heat for the power semiconductor device. The heat dissipation component can ensure that the temperature of the power semiconductor device is maintained within a reasonable temperature range when the power semiconductor device works.

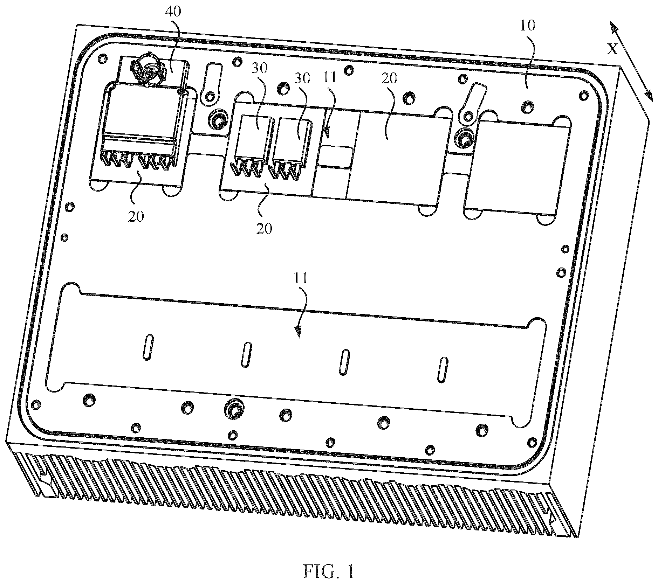

FIG. 1 is a diagram of a three-dimensional structure of a heat dissipation component in a conventional technology. As shown in FIG. 1, in the conventional technology, the heat dissipation component includes a heat sink 10, a ceramic substrate 20, and a pressing module 40. A surface of the heat sink 10 is provided with a fixing groove 11. A part of the ceramic substrate 20 is inserted into the fixing groove 11, and a bottom surface of the ceramic substrate 20 is in close contact with a groove bottom of the fixing groove 11. A power semiconductor device 30 is located on a top surface of the ceramic substrate 20 and is in close contact with the ceramic substrate 20. A first end of the pressing module 40 is fixedly connected to the heat sink 10, and a second end of the pressing module 40 is in close contact with the ceramic substrate 20 and is overlapped on a surface that is of the power semiconductor device 30 and that is opposite to the ceramic substrate 20. The pressing module 40 is fixedly connected to the heat sink 10, so that the power semiconductor device 30 and the ceramic substrate 20 may be pressed on the groove bottom of the fixing groove 11, and the power semiconductor device 30 and the ceramic substrate 20 do not move in a vertical direction (for example, an X direction in FIG. 1). Because the heat sink 10 is made of metal, the heat sink 10 cannot contact the power semiconductor device 30. As shown in FIG. 1, the ceramic substrate 20 may be disposed between the power semiconductor device 30 and the heat sink 10, and the ceramic substrate 20 may perform functions of heat conduction and insulation isolation. The part of the ceramic substrate 20 is located in the fixing groove 11, so that the ceramic substrate 20 may abut against a side wall of the fixing groove 11 in a horizontal direction (a direction perpendicular to the X direction in FIG. 1) parallel to the surface of the heat sink 10. In this way, movement of the ceramic substrate 20 on the surface of the heat sink 10 can be restricted. Because a quantity of power semiconductor devices 30 is large, a plurality of ceramic substrates 20 are required. Therefore, in a processing process of the heat sink 10, a large-area fixing groove 11 needs to be milled on the surface of the heat sink 10 through a groove milling process. However, addition of the groove milling process increases a processing time period of the heat sink 10, thereby reducing production efficiency of the heat sink 10, and further reducing production efficiency of an inverter.

In view of this, this embodiment of this application provides a power converter. According to the power converter provided in this embodiment of this application, a manner of fastening the ceramic substrate on the heat sink by using the large-area fixing groove is abandoned, and a limiting structure is disposed between the ceramic substrate and the heat sink, to limit movement of the ceramic substrate on the surface of the heat sink. Because the limiting structure does not have the large-area fixing groove, the milling groove process can be removed in the processing process of the heat sink, thereby improving the production efficiency of the heat sink and further improving production efficiency of the power converter.

It should be noted that, in this embodiment of this application, the power converter may include but is not limited to an inverter, a rectifier, a frequency converter, and the like.

The following describes an implementation of a power converter provided in an embodiment of this application.

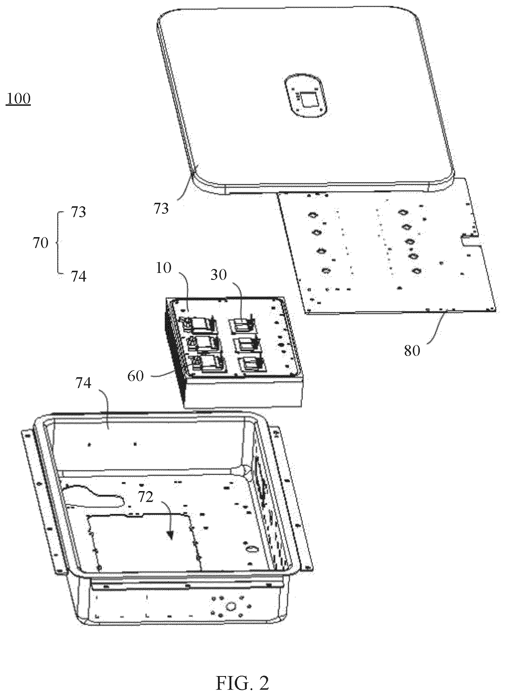

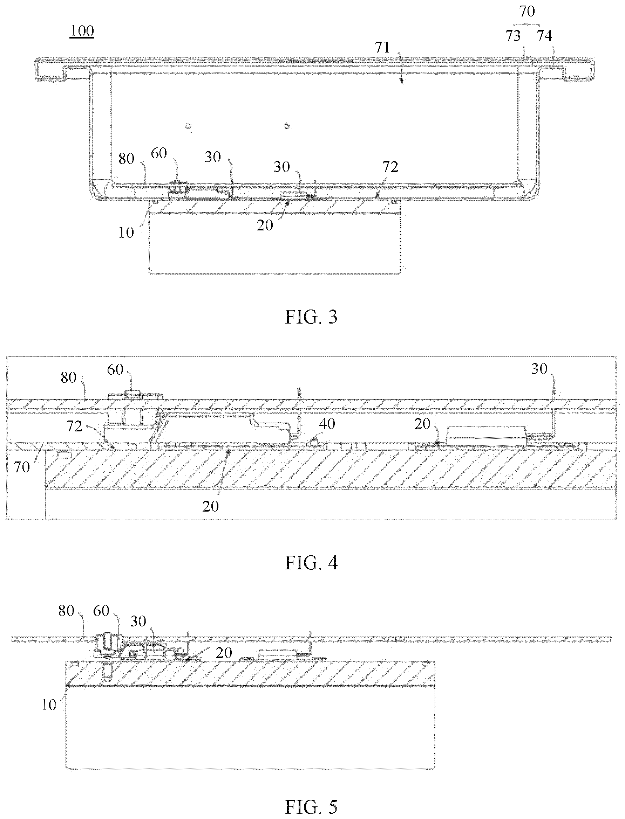

FIG. 2 is an exploded view of a power converter 100 according to an embodiment of this application. FIG. 3 is a sectional view of the power converter 100 according to the embodiment shown in FIG. 2. FIG. 4 is a partial enlarged view at an insulating substrate 20 in FIG. 3. As shown in FIG. 2 to FIG. 4, the power converter 100 provided in this embodiment of this application may include a housing 70, a circuit board 80, a heat sink 10, at least one power semiconductor device 30, at least one thermally conductive insulating substrate 20, and at least two limiting structures. Being thermally conductive means that heat generated by the power semiconductor device 30 may be transferred to the heat sink 10 through the insulating substrate 20. Insulation means that a current in the power semiconductor device 30 is not transmitted to the heat sink 10 through the insulating substrate 20, thereby achieving electrical insulation.

The housing 70 includes an accommodation cavity 71 and a through opening 72, and the through opening 72 is in communication with the accommodation cavity 71. The heat sink 10 is located at the through opening 72 and outside the accommodation cavity 71, and the heat sink 10 is fixedly connected to the housing 70. A plurality of insulating substrates 20 are located in the through opening 72 and are fixedly mounted on a surface that is of the heat sink 10 and that faces the through opening 72, and each insulating substrate 20 corresponds to two limiting structures. The at least one power semiconductor device 30 is fixedly mounted on a surface of that is of each insulating substrate 20 and that is opposite to the heat sink 10, and each power semiconductor device 30 is electrically connected to the circuit board 80. The circuit board 80 is fixedly mounted in the accommodation cavity 71 and is higher than the power semiconductor device 30 in a height direction of the power converter 100. Each limiting structure includes a fitting part 50 and a fixing part 40 that cooperates with the fitting part 50. The fitting part 50 is disposed on the insulating substrate 20, and the fixing part 40 is disposed on a surface on which the heat sink 10 is in contact with the insulating substrate 20.

A quantity of the insulating substrate 20 may be 1, 2, 3, 4, 5, 6, 7, 8, 9, or the like. This is not limited herein. When there is one insulating substrate 20, all the power semiconductor devices 30 share the same insulating substrate 20. In other words, 1, 2, 3, or 4 power semiconductor devices 30 may be disposed on the surface that is of the insulating substrate 20 and that is opposite to the heat sink 10. When there are more than two insulating substrates 20, at least one power semiconductor device 30 is disposed on each insulating substrate 20. For example, in some embodiments, as shown in FIG. 5, two power semiconductor devices 30 are disposed on the surface that is of each insulating substrate 20 and that is opposite to the heat sink 10.

The insulating substrate 20 is made of a thermally conductive and insulating material, so as to ensure that the heat generated by the power semiconductor device 30 is transferred to the heat sink 10 and that the power semiconductor device 30 is insulated from the heat sink 10. For example, in some embodiments, the insulating substrate 20 is a ceramic substrate made of ceramic.

A shape of the insulating substrate 20 may be a circle, an arc, a semicircle, or a polygon. This is not specifically limited herein. For example, as shown in FIG. 3, the shape of the insulating substrate 20 is a rectangle.

In this embodiment of this application, each insulating substrate 20 may correspond to two limiting structures, and each insulating substrate 20 may alternatively correspond to 3, 4, 5, 6, or 7 limiting structures.

Each insulating substrate 20 cooperates with the heat sink 10 by using two limiting structures. The two limiting structures can prevent the insulating substrate 20 from moving on a surface of the heat sink 10, and can ensure that a position of the insulating substrate 20 on the surface of the heat sink 10 remains unchanged. Each limiting structure includes one fitting part 50 and one fixing part 40, and a position of each insulating substrate 20 is ensured by using two fixing parts 40 and two fitting parts 50. Therefore, in a processing process of the heat sink 10, a groove milling process can be removed, so that a processing time period of the heat sink 10 is reduced.

In this embodiment of this application, a specific shape of the through opening 72 is not limited herein. For example, in some embodiments, as shown in FIG. 2, the through opening 72 may be rectangular.

In this embodiment of this application, a specific structure of the housing 70 is not limited herein. For example, in some embodiments, as shown in FIG. 2 and FIG. 3, the housing 70 may include an upper cover and a bottom housing 74. The cover plate 73 is covered on a top end of the bottom housing 74 and is fixedly connected to the bottom housing 74, and the cover plate 73 and the bottom housing 74 jointly define the accommodation cavity 71. The through opening 72 is provided on an inner wall that is of the bottom housing 74 and that faces the cover plate 73. The bottom housing 74 is fixedly connected to the heat sink 10.

The heat sink 10 may be fixedly connected to the housing 70 in a manner such as clamping or threaded connection. This is not limited herein.

In this embodiment of this application, the heat sink 10 is located outside the accommodation cavity 71. However, in some embodiments, a part of the heat sink 10 may pass through the through opening 72 and be located in the accommodation cavity 71.

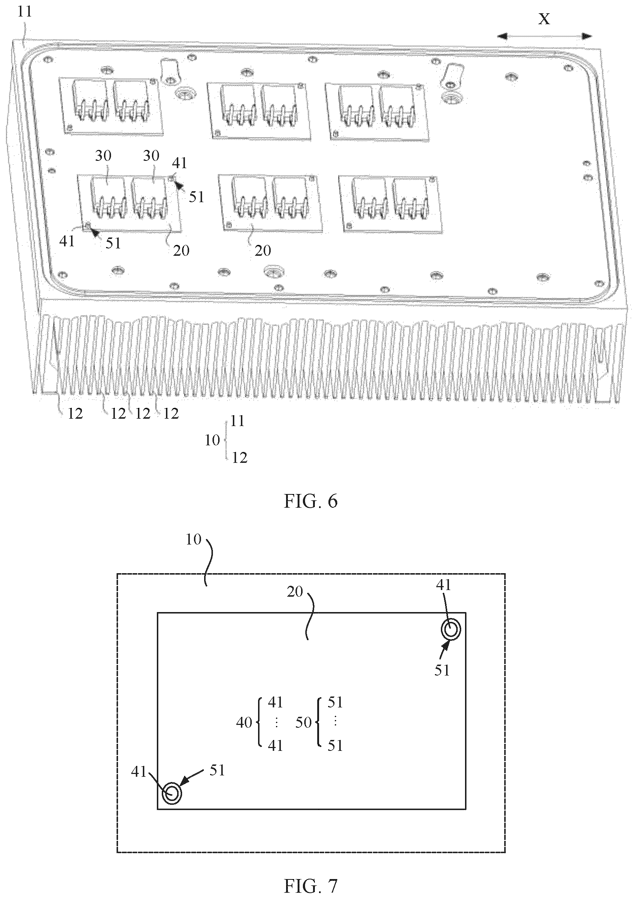

FIG. 5 is a partial sectional view of the power converter 100 after the housing 70 is removed according to the embodiment shown in FIG. 2. FIG. 6 is a diagram of a partial structure of cooperation between the heat sink 10 and the first insulating substrate 20 according to the embodiment shown in FIG. 2. In this embodiment of this application, a specific structure of the heat sink 10 is not limited herein. For example, in a possible implementation, as shown in FIG. 5 and FIG. 6, the heat sink 10 may include a metal body part 11 and a plurality of plate-shaped parts 12. The metal body part 11 is close to the through opening 72 and is fixedly connected to the heat sink 10, and the insulating substrate 20 is fixedly mounted on a surface that is of the metal body part 11 and that faces the through opening 72. The plurality of plate-shaped parts 12 are fixedly connected to the metal body part 11 and are located on a surface that is of the metal body part 11 and that is opposite to the insulating substrate 20, and the plurality of plate-shaped parts 12 are disposed at intervals along a length direction of the metal body part 11. Using the heat sink 10 with such a structure can increase a heat exchange area between the heat sink 10 and the air, and improve a heat dissipation capability of the heat sink 10.

As shown in FIG. 6, a shape of the metal body part 11 may be a plate-shaped structure, so as to ensure that the plurality of insulating substrates 20 may be located on the surface that is of the metal body part 11 and that faces the through opening 72. In addition, in some embodiments, the metal body part 11 and the plurality of plate-shaped parts 12 may be an integral structure, and this helps to improve connection strength between the metal body part 11 and the plate-shaped parts 12.

It should be noted that, the heat sink 10 may include the metal body part 11 and the plate-shaped parts 12. In some embodiments, the heat sink 10 may alternatively be an air-cooled heat sink or a liquid-cooled heat sink.

In some possible implementations, as shown in FIG. 5, the power converter 100 may further include a pressing member 60. A first end of the pressing member 60 is fixedly connected to a surface end that is of the heat sink 10 and that faces the through opening 72, a second end of the pressing member 60 abuts against the power semiconductor device 30, and the pressing member 60 is configured to fasten the power semiconductor device 30 and the insulating substrate 20 to the heat sink 10. Because the pressing member 60 is fixedly connected to the heat sink 10, the pressing member 60 may apply a pressing force to the power semiconductor device 30 in a direction perpendicular to the insulating substrate 20, so as to press the power semiconductor device 30 on the insulating substrate 20, and the power semiconductor device 30 presses the insulating substrate 20 on the heat sink 10.

Each pressing member 60 may press two power semiconductor devices 30 on one insulating substrate 20. In some embodiments, each pressing member 60 may alternatively press 1, 3, 4, or 5 power semiconductor devices 30 on one insulating substrate 20.

The pressing member 60 may be fixedly connected to the heat sink 10 in a manner such as clamping, or threaded connection. For example, in some embodiments, the first end of the pressing member 60 has a through hole through which a fixing screw (not shown in the figure) passes, and the fixing screw is threadedly connected to the heat sink 10 to fasten the pressing member 60 on the heat sink 10.

In some embodiments, as shown in FIG. 5, a third end of each pressing member 60 may be further fixedly connected to the circuit board 80. The circuit board 80 may be fastened to the housing 70 by using the pressing member 60 and the heat sink 10. Relative positions of the circuit board 80 and the power semiconductor device 30 are ensured by using the pressing member 60, so that an application range of the pressing member 60 can be improved, and structure complexity of the power converter 100 can be reduced.

The pressing member 60 may be fixedly connected to the circuit board 80 in a manner such as clamping or threaded connection. This is not limited herein. For example, in some embodiments, as shown in FIG. 5, the third end of the pressing member 60 is inserted into the through hole on the circuit board 80 and is clamped with the circuit board 80.

A structure of the pressing member 60 is not specifically limited herein. The structure of the pressing member 60 may be determined based on a quantity of power semiconductor devices 30 pressed by each pressing member 60 and a structure of the circuit board 80.

In some possible implementations, as shown in FIG. 6, each fixing part 40 may be a fixing post 41, and a connection end of the fixing post 41 is fixedly connected to the heat sink 10. Each fitting part 50 is a fitting hole 51 that penetrates the insulating substrate 20, and the fitting hole 51 is used for inserting the fixing post 41. Because the fixing post 41 is inserted into the fitting hole 51, an inner wall of the fitting hole 51 abuts against the fixing post 41, and the fixing post 41 is fixedly connected to the heat sink 10, so that the insulating substrate 20 cannot move on the surface of the heat sink 10.

It should be noted that movement of the insulating substrate 20 on the surface of the heat sink 10 means that the insulating substrate 20 moves on the surface of the heat sink 10 in a horizontal direction (an X direction in FIG. 6), or the insulating substrate 20 rotates around a rotation axis (perpendicular to the X direction in FIG. 6) perpendicular to the insulating substrate 20. Therefore, when the fixing part 40 cooperates with the fitting part 50 and the insulating substrate 20 is in contact with the surface of the heat sink 10, the position of the insulating substrate 20 on the surface of the heat sink 10 remains unchanged.

When the limiting structure including the fixing post 41 and the fitting hole 51 is adopted, the groove milling process can be removed in the processing process of the heat sink 10, and correspondingly, only an erection pillar process needs to be added to form the fixing post 41. Compared with production efficiency of the existing heat sink 10, production efficiency of the power converter 100 can be improved. The erection pillar process refers to a process of fastening the fixing post 41 to the surface of the heat sink 10.

A structure of the fixing post 41 may depend on a shape of the fitting hole 51. This is not limited herein. For example, in some embodiments, if the fitting hole 51 is a round hole, the fixing post 41 is a cylinder. Alternatively, in some embodiments, if the fitting hole 51 is a square hole, the fixing post 41 is a square column, and a cross section of the fixing post 41 is the same as a shape of the square hole. The cross section of the fixing post 41 is perpendicular to an axis of the fixing post 41. Therefore, a form of the fitting hole 51 includes, but is not limited to, the round hole and the square hole.

The fixing post 41 may be fixedly connected to the heat sink 10 in a manner such as threaded connection, or crimping. For example, in some embodiments, a through hole into which a part of the fixing post 41 is inserted is provided on the surface on which the heat sink 10 is in contact with the insulating substrate 20, and then the fixing post 41 is pressed into the through hole. The fixing post 41 and the heat sink 10 are fastened by an interference force between the fixing post 41 and a side wall of the through hole.

FIG. 7 is a partial schematic diagram of cooperation between the heat sink 10 and the first insulating substrate 20 according to the embodiment shown in FIG. 6. In some embodiments, as shown in FIG. 6 and FIG. 7, two fitting holes 51 may be located at two opposite diagonals of the insulating substrate 20. In other words, the two fitting holes 51 are disposed at intervals along a circumferential direction of the insulating substrate 20. Therefore, when there are more than two fitting holes 51, all the fitting holes 51 may be disposed at intervals along the circumferential direction of the insulating substrate 20.

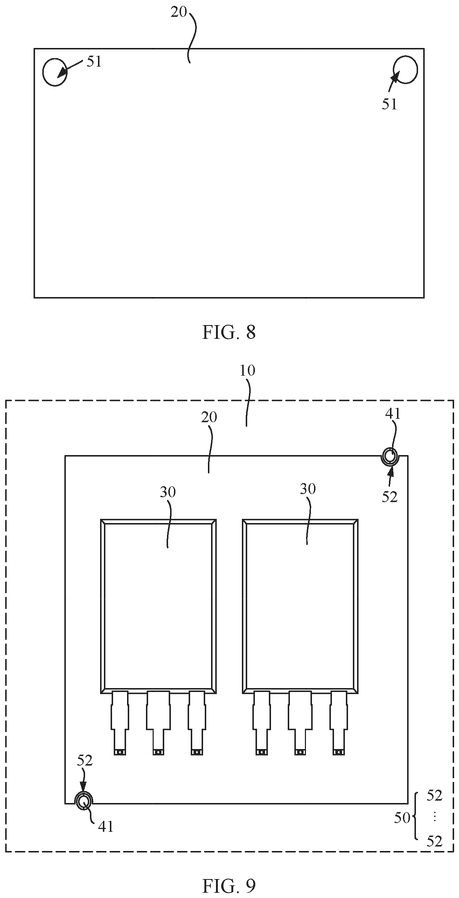

However, in addition to being disposed at intervals along the circumferential direction of the insulating substrate 20, in some embodiments, all the fitting holes 51 may alternatively be located on a same side of the insulating substrate 20. For example, as shown in FIG. 8, the two fitting holes 51 are located on the same side of the insulating substrate 20. FIG. 8 is a schematic diagram of a second insulating substrate 20 according to an embodiment of this application. Alternatively, in some embodiments, a plurality of fitting holes 51 are distributed on two adjacent sides of the insulating substrate 20 (not shown in the figure). Alternatively, in some embodiments, all fitting holes 51 may be randomly distributed on the insulating substrate 20 (not shown in the figure).

It may be understood that, because the fixing posts 41 are in a one-to-one correspondence with the fitting holes 51, an arrangement manner of the fixing posts 41 is the same as an arrangement manner of the fitting holes 51, so as to ensure that each fixing post 41 can be inserted into a fitting hole 51 corresponding to the fixing posts 41.

In some possible implementations, to improve heat transfer efficiency from the power semiconductor device 30 to the heat sink 10, thermally conductive silicone grease may be applied between the power semiconductor device 30 and the insulating substrate 20. In addition, the thermally conductive silicone grease may be applied between the insulating substrate 20 and the heat sink 10.

In the foregoing description, each limiting structure includes one fitting hole 51 and one fixing post 41 for inserting the fitting hole 51. However, a specific structure of the limiting structure may alternatively be another structure. Limiting structures of several other structures are described below.

FIG. 9 is a diagram of a partial structure of a second power converter 100 including a third insulating substrate 20 according to an embodiment of this application. As shown in FIG. 9, a difference between FIG. 9 and FIG. 7 lies in that, the fitting hole 51 in each limiting structure is replaced with a fitting notch 52, and the fixing post 41 in each limiting structure is inserted into a corresponding fitting notch 52. When the insulating substrate 20 moves on the surface of the heat sink 10, the fixing post 41 is clamped into the fitting notch 52, so that the fixing post 41 abuts against a side wall of the fitting notch 52, thereby preventing the insulating substrate 20 from moving. Therefore, the insulating substrate 20 may be fastened on the surface of the heat sink 10 by clamping the fixing post 41 into the fitting notch 52, so as to ensure that the insulating substrate 20 does not horizontally move or rotate on the surface of the heat sink 10. In addition, the production efficiency of the power converter 100 can be improved.

The structure of the fixing post 41 may be the cylinder or the square column. This is not specifically limited herein. In addition, the fixing post 41 may be fixedly connected to the heat sink 10 in a manner such as threaded connection, or crimping.

In some embodiments, as shown in FIG. 9, two fitting notches 52 may be located at two opposite diagonals of the insulating substrate 20, in other words, the two fitting notches 52 are disposed at intervals along the circumferential direction of the insulating substrate 20. Therefore, when there are more than two fitting notches 52, all the fitting notches 52 may be disposed at intervals along the circumferential direction of the insulating substrate 20. For example, each insulating substrate 20 is provided with three fitting notches 52 disposed at intervals along the circumferential direction of the insulating substrate 20.

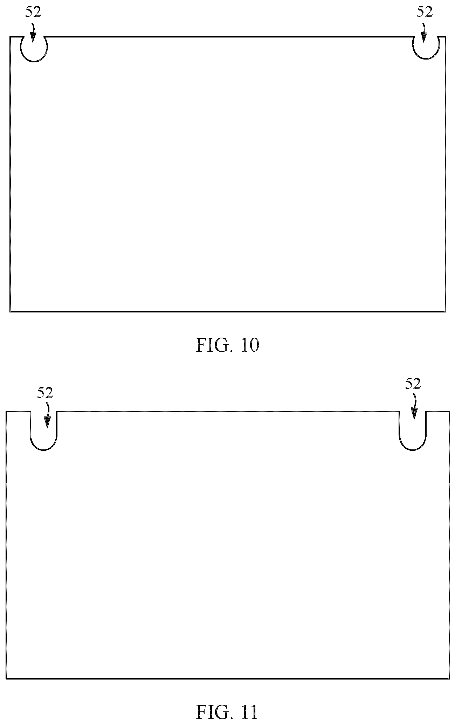

However, in addition to being disposed at intervals along the circumferential direction of the insulating substrate 20, in some embodiments, all the fitting notches 52 may alternatively be located on a same side of the insulating substrate 20. For example, as shown in FIG. 10, the two fitting notches 52 are located on the same side of the insulating substrate 20. FIG. 10 is a schematic diagram of a fourth insulating substrate 20 according to an embodiment of this application. Alternatively, in some embodiments, a plurality of fitting notches 52 are distributed on adjacent sides of the insulating substrate 20 (not shown in the figure). Alternatively, in some embodiments, all the fitting notches 52 may be randomly distributed on the insulating substrate 20 (not shown in the figure).

It may be understood that, because the fixing posts 41 are in a one-to-one correspondence with the fitting notches 52, the arrangement manner of the fixing posts 41 is the same as an arrangement manner of the fitting notches 52, so as to ensure that each fixing post 41 can be inserted into a fitting notch 52 corresponding to the fixing posts 41.

A specific structure of the fitting notch 52 is not limited herein. For example, in some embodiments, the fitting notch 52 is a semicircular hole. Alternatively, in some embodiments, as shown in FIG. 10, the fitting notch 52 may be a three-quarter round hole. Alternatively, in some embodiments, the fitting notch 52 may be a two-thirds round hole. Alternatively, in some embodiments, as shown in FIG. 11, the fitting notch 52 may be a half slotted hole. FIG. 11 is a schematic diagram of a fifth insulating substrate 20 according to an embodiment of this application. Alternatively, in some embodiments, the fitting notch 52 may be a polygonal notch, for example, the fitting notch 52 may be a rectangular notch (not shown in the figure).

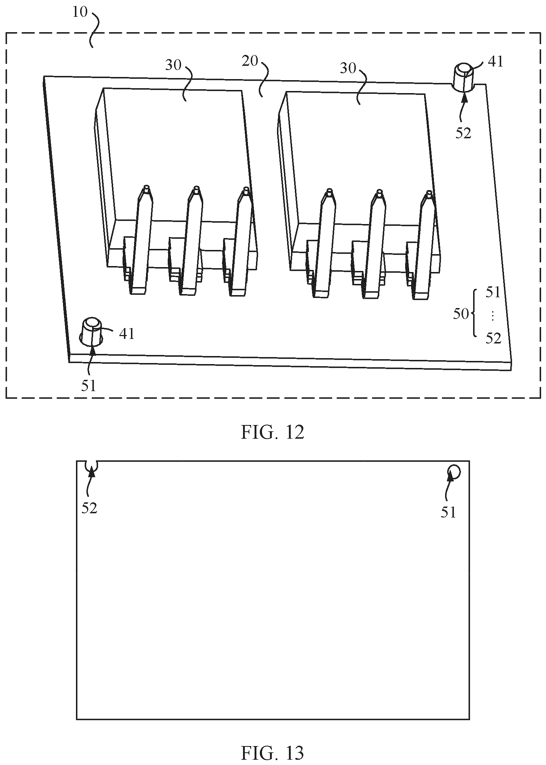

FIG. 12 is a diagram of a partial structure of a third power converter 100 including a sixth insulating substrate 20 according to an embodiment of this application. A difference between FIG. 12 and FIG. 7 lies in that, one of the two fitting holes 51 on each insulating substrate 20 is replaced with the fitting notch 52, so that one fitting notch 52 and one fitting hole 51 are disposed on each insulating substrate 20. Each fixing post 41 on the heat sink 10 is inserted into a fitting notch 52 or a fitting hole 51 corresponding to the fixing post 41. The insulating substrate 20 may be fastened on the surface of the heat sink 10 by inserting the fixing post 41 into the fitting hole 51 or the fitting notch 52, so as to ensure that the insulating substrate 20 does not horizontally move or rotate on the surface of the heat sink 10.

It should be noted that, when each insulating substrate 20 corresponds to more than two limiting structures, a quantity of fitting holes 51 on each insulating substrate 20 may be the same as or different from a quantity of fitting notches 52. For example, in some embodiments, each insulating substrate 20 corresponds to three limiting structures. Therefore, three fitting parts 50 are disposed on the insulating substrate 20, two fitting parts 50 of the three fitting parts 50 are the fitting holes 51, and one fitting part 50 is the fitting notch 52. Alternatively, in some embodiments, each insulating substrate 20 corresponds to four limiting structures. Therefore, four fitting parts 50 are disposed on the insulating substrate 20, two fitting parts 50 of the four fitting parts 50 are the fitting holes 51, and two fitting parts 50 are the fitting notches 52.

The fitting hole 51 may be a round hole, a slotted hole, or a polygonal hole. This is not limited herein. For example, as shown in FIG. 12, the fitting hole 51 is the round hole.

The specific structure of the fitting notch 52 is not limited herein. For example, as shown in FIG. 12, the fitting notch 52 is the semicircular hole. Alternatively, in some embodiments, the fitting notch 52 may be the three-quarter round hole. Alternatively, in some embodiments, the fitting notch 52 may be the two-thirds round hole. Alternatively, in some embodiments, the fitting notch 52 may be the half slotted hole. Alternatively, in some embodiments, the fitting notch 52 may be the polygonal notch.

In some embodiments, as shown in FIG. 12, one fitting hole 51 and one fitting notch 52 on each insulating substrate 20 are provided at diagonals of the insulating substrate 20. In other words, the fitting part 50 and the fitting notch 52 on each insulating substrate 20 may be disposed at intervals along the circumferential direction of the insulating substrate 20. When a total quantity of the fitting holes 51 and the fitting notches 52 on each insulating substrate 20 is greater than 2, all the fitting holes 51 and all the fitting notches 52 on each insulating substrate 20 may be alternately disposed along the circumferential direction of the insulating substrate 20. Alternatively, all the fitting holes 51 and all the fitting notches 52 on each insulating substrate 20 may be disposed at intervals along the circumferential direction of the insulating substrate 20, and all the fitting holes 51 and all the fitting notches 52 do not need to be alternately disposed along the circumferential direction of the insulating substrate 20.

However, in addition to being disposed along the circumferential direction of the insulating substrate 20, in some embodiments, the fitting part 50 and the fitting notch 52 on each insulating substrate 20 may alternatively be located on a same side of the insulating substrate 20. FIG. 13 is a schematic diagram of a seventh insulating substrate 20 according to an embodiment of this application. For example, as shown in FIG. 13, one fitting hole 51 and one fitting notch 52 are located on the same side of the insulating substrate 20. Alternatively, in some embodiments, the fitting hole 51 on each insulating substrate 20 is located on a first side of the insulating substrate 20, and the fitting notch 52 on each insulating substrate 20 is located on a second side of the insulating substrate 20. The first side of the insulating substrate 20 and the second side of the insulating substrate 20 are adjacent sides of the insulating substrate 20.

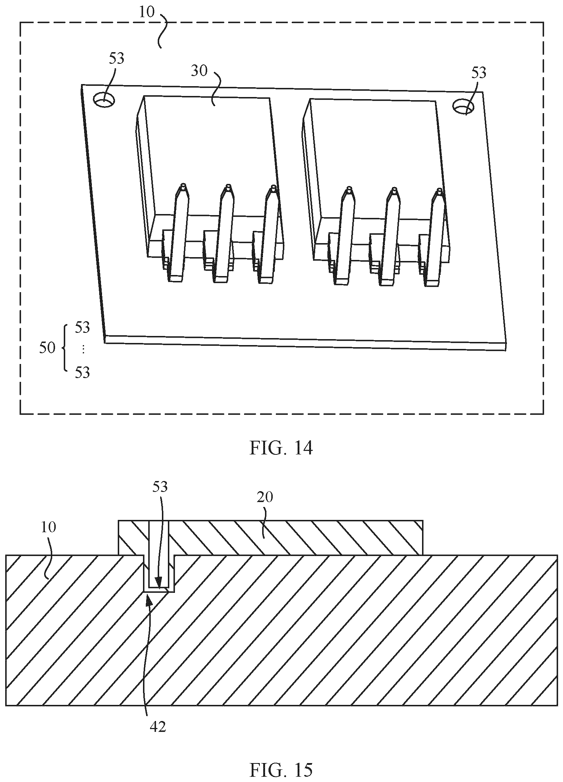

FIG. 14 is a diagram of a partial structure of a fourth power converter 100 including an eighth insulating substrate 20 according to an embodiment of this application. FIG. 15 is a partial sectional view of cooperation between the heat sink 10 and the insulating substrate 20 according to the embodiment shown in FIG. 14. A difference between FIG. 14 and FIG. 7 lies in that, each fixing part 40 may be a fixing hole 42 located on the surface on which the heat sink 10 is in contact with the insulating substrate 20, and each fitting part 50 may be a fitting protrusion 53. Two fitting protrusions 53 are in a one-to-one correspondence with two fixing holes 42, a connection end of each fitting protrusion 53 is fixedly connected to the insulating substrate 20, and each fitting protrusion 53 is inserted into a fixing hole 42 corresponding to the fitting protrusion 53 (as shown in FIG. 15). When the insulating substrate 20 moves on the surface of the heat sink 10, because the fitting protrusion 53 is inserted into the fixing hole 42, the fitting protrusion 53 abuts against a side wall of the fixing hole 42, so that the insulating substrate 20 may be fastened on the surface of the heat sink 10 in the horizontal direction. It can be ensured that the insulating substrate 20 cannot move on the surface of the heat sink 10. In addition, the milling process can be removed in the processing process of the heat sink 10 by using the fitting part 50 and the fixing part 40 of this structure, thereby improving the production efficiency of the heat sink 10 and helping to improve the production efficiency of the power converter 100.

The fixing hole 42 may be the round hole, the slotted hole, or the polygonal hole. This is not limited herein. For example, in some embodiments, the fixing hole 42 is the round hole.

In addition to the two fitting protrusions shown in FIG. 14, a quantity of the fitting protrusions 53 may alternatively be three, four, five, six, or the like. When there are more than two fitting protrusions 53, the quantity of the fitting protrusions 53 is equal to a quantity of the fixing holes 42.

The fitting protrusion 53 may be in a shape of a cylinder, a prism, a cone, or a boss. This is not specifically limited herein. In addition, the fitting protrusion 53 and the insulating substrate 20 may be an integral structure, or the fitting protrusion 53 and the insulating substrate 20 may be detachably connected.

As shown in FIG. 15, the fitting protrusion 53 may be located on the surface on which the insulating substrate 20 is in contact with the heat sink 10. Alternatively, in some embodiments, the fitting protrusion 53 may be located on a side wall of the insulating substrate 20 (not shown in the figure).

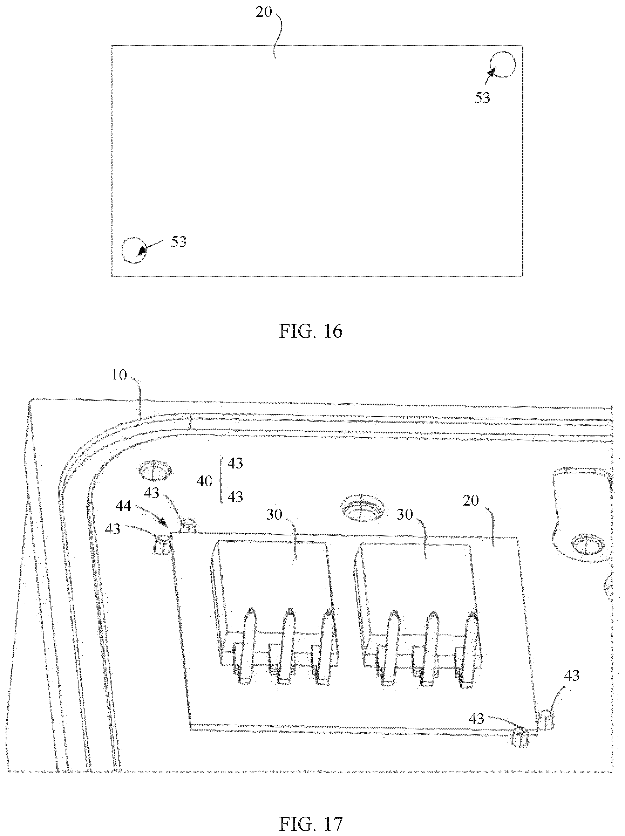

As shown in FIG. 14, the two fitting protrusions 53 may be located on the same side of the insulating substrate 20. However, in addition to being located on the same side of the insulating substrate 20, the two fitting protrusions 53 may alternatively be located on different sides of the insulating substrate 20. FIG. 16 is a bottom view of a ninth insulating substrate 20 according to an embodiment of this application. For example, in some embodiments, as shown in FIG. 16, the two fitting protrusions 53 are located at diagonals of the insulating substrate 20, in other words, the two fitting protrusions 53 are disposed at intervals along the circumferential direction of the insulating substrate 20. Alternatively, in some embodiments, the two fitting protrusions 53 are located on two adjacent sides of the insulating substrate 20 (not shown in the figure).

It may be understood that, when there are more than two fitting protrusions 53, all fitting protrusions 53 may be disposed at intervals along the circumferential direction of the insulating substrate 20, or all fitting protrusions 53 may be located on different sides of the insulating substrate 20. In addition, an arrangement manner of the fixing holes 42 is the same as an arrangement manner of the fitting protrusions 53, so as to ensure that each fitting protrusion 53 can be inserted into a fixing hole 42 corresponding to the fitting protrusion 53.

In the foregoing description, the fitting part 50 is formed by opening a hole, a notch, or a protrusion on the insulating substrate 20. However, in some embodiments, no additional design of the insulating substrate 20 is required, and the insulating substrate 20 may be fastened to the surface of the heat sink 10 in the horizontal direction by using a part of the insulating substrate 20 as the fitting part 50 that cooperates with the fixing part 40. Specifically, at least two fixing parts 40 corresponding to each insulating substrate 20 are disposed at intervals along the circumferential direction of the insulating substrate 20. Each fixing part 40 includes a fixing structure that cooperates with a part of the insulating substrate 20, and the part that is of the insulating substrate 20 and that cooperates with the fixing structure is used as the fitting part 50. Fastening the insulating substrate 20 by using a structure of the insulating substrate 20 can prevent the insulating substrate 20 from moving on the surface of the heat sink 10. Therefore, there is no need to perform operations such as opening a hole, a post, or a boss on the insulating substrate 20, thereby improving production efficiency of the insulating substrate 20 and further improving the production efficiency of the power converter 100.

FIG. 17 is a diagram of a partial structure of a fifth power converter 100 including a fixing notch 44 according to an embodiment of this application. A difference between FIG. 17 and FIG. 7 lies in that, each fixing part 40 may include two fixing protrusions 43 disposed at intervals. A connection end of each fixing protrusion 43 is fixedly connected to the heat sink 10, and two fixing protrusions 43 and the surface of the heat sink 10 jointly define the fixing notch 44. The two diagonals of the insulating substrate 20 are respectively inserted into the two fixing notches 44, and the diagonals of the insulating substrate 20 are respectively in contact with the two fixing protrusions 43. When the insulating substrate 20 tends to move on the surface of the heat sink 10, the two fixing protrusions 43 abut against side walls of the insulating substrate 20, and the insulating substrate 20 may be clamped, so that the insulating substrate 20 cannot move on the surface of the heat sink 10.

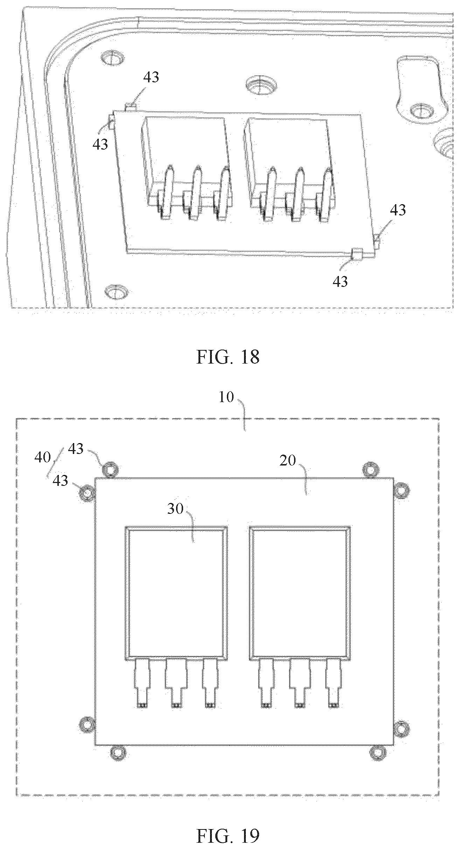

A structure of the fixing protrusion 43 may be a structure such as a cylinder, a prism, or a long strip boss. This is not specifically limited herein. For example, as shown in FIG. 17, each fixing part 40 includes two cylinders. Alternatively, in some embodiments, as shown in FIG. 18, each fixing part 40 includes two long strip bosses. FIG. 18 is a schematic diagram in which the fixing protrusion 43 is the long strip boss according to an embodiment of this application.

It may be understood that, in addition to two fixing notches 44 corresponding to each insulating substrate 20, a quantity of the fixing notches 44 may alternatively be three, four, five, six, or the like. When there are more than two fixing notches 44 corresponding to each insulating substrate 20, all the fixing notches 44 may be disposed at intervals along the circumferential direction of the insulating substrate 20. FIG. 19 is a diagram of a partial structure of a sixth power converter 100 including four fixing notches 44 according to an embodiment of this application. For example, as shown in FIG. 19, there are four fixing notches 44, the four fixing notches 44 are located at four diagonals of the insulating substrate 20, and the four diagonals of the insulating substrate 20 are respectively inserted into the four fixing notches 44.

A connection manner between the fixing protrusion 43 and the heat sink 10 may be determined based on the structure of the fixing protrusion 43. This is not limited herein. For example, when the fixing protrusion 43 is the cylinder, the fixing protrusion 43 may be fixedly connected to the heat sink 10 in a manner such as threaded connection, or crimping. Alternatively, when the fixing protrusion 43 is a long strip protrusion, the fixing protrusion 43 may be fixedly connected to the heat sink 10 in a manner such as welding or crimping.

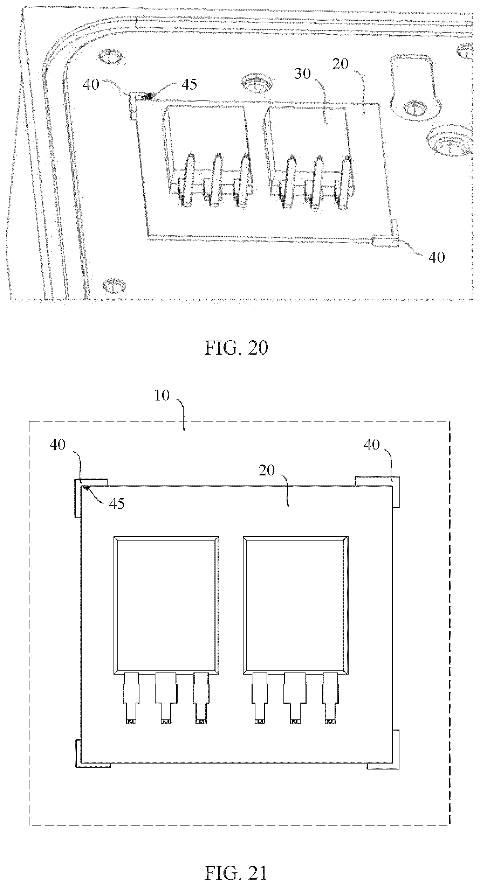

FIG. 20 is a diagram of a partial structure of a seventh power converter 100 including two fixing grooves 45 according to an embodiment of this application. A difference between FIG. 20 and FIG. 7 lies in that, a side wall that is of each fixing part 40 and that faces the insulating substrate 20 defines the fixing groove 45. The diagonal of the insulating substrate 20 is inserted into the fixing groove 45 and is in contact with an inner wall of the fixing groove 45. When the insulating substrate 20 tends to move on the surface of the heat sink 10, a part of the insulating substrate 20 extends into the fixing groove 45, so that a side wall of the fixing groove 45 abuts against the side wall of the insulating substrate 20, and the fixing part 40 can clamp the insulating substrate 20. In this way, the insulating substrate 20 cannot move on the surface of the heat sink 10.

It may be understood that, in addition to two fixing grooves 45 corresponding to each insulating substrate 20, a quantity of the fixing grooves 45 may alternatively be three, four, five, six, or the like. In addition, when there are more than two fixing grooves 45 corresponding to each insulating substrate 20, all the fixing grooves 45 may be disposed at intervals along the circumferential direction of the insulating substrate 20. FIG. 21 is a diagram of a partial structure of an eighth power converter 100 including the fixing groove 45 according to an embodiment of this application. For example, as shown in FIG. 21, there are four fixing grooves 45 corresponding to each insulating substrate 20, the four fixing grooves 45 are located at the four diagonals of the insulating substrate 20, and the four diagonals of the insulating substrate 20 are respectively inserted into the four fixing grooves 45.

A specific structure of the fixing part 40 forming the fixing groove 45 is not limited herein. For example, in some embodiments, a cross section of the fixing part 40 may include a first fixing section and a second fixing section, and a first end of the first fixing section is fixedly connected to a second end of the second fixing section. A side surface that is of the first fixing section and that faces the insulating substrate 20 and a side surface that is of the second fixing section and that faces the insulating substrate 20 define the fixing groove 45.

Specific shapes of the first fixing section and the second fixing section are not limited herein. For example, in some embodiments, as shown in the figure, both the first fixing segment and the second fixing segment may be rectangular.

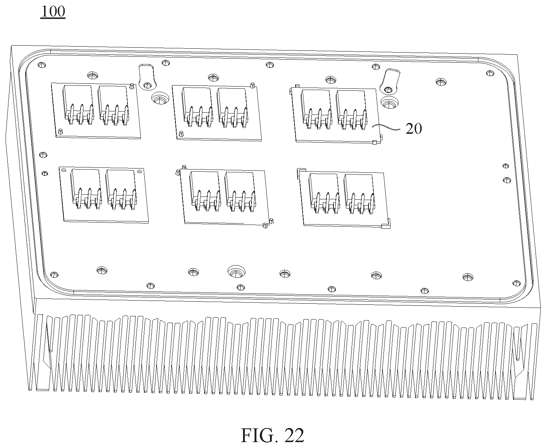

It should be noted that, because there are a plurality of insulating substrates 20, there are a plurality of specific structures of the limiting structure formed by the fitting part 50 and the fixing part 40. Therefore, limiting structures corresponding to the plurality of insulating substrates 20 may be the same or different. For example, in some embodiments, the plurality of insulating substrates 20 correspond to two limiting structures. For example, some insulating substrates 20 correspond to the limiting structure formed by the fixing post 41 and the fitting hole 51, and the other insulating substrates 20 correspond to the limiting structure formed by the fixing post 41 and the fitting notch 52. Alternatively, in some embodiments, as shown in FIG. 22, each of six insulating substrates 20 corresponds to one unique limiting structure. FIG. 22 is a schematic diagram of a structure of a ninth power converter 100 including six limiting structures according to an embodiment of this application.

In descriptions of embodiments of this application, it should be noted that, unless otherwise clearly specified and limited, the terms "mounting", "connection to", and "connection" should be understood in a broad sense. For example, the connection may be a fixed connection, may be an indirect connection by using an intermediate medium, or may be an internal connection between two elements or an interaction relationship between two elements. For persons of ordinary skill in the art, specific meanings of the foregoing terms in embodiments of this application may be understood based on a specific situation.

In the specification, claims, and accompanying drawings of embodiments of this application, the terms "first", "second", "third", "fourth", and so on (if existent) are intended to distinguish between similar objects but do not necessarily indicate a specific order or sequence.

## Claims

1. A power converter, comprising a housing, a circuit board, a heat sink, at least one power semiconductor device, at least one thermally conductive insulating substrate, and at least two limiting structures, wherein
the housing comprises an accommodation cavity and a through opening, and the through opening is in communication with the accommodation cavity;
the heat sink is located at the through opening and outside the accommodation cavity, and the heat sink is fixedly connected to the housing;
the at least one insulating substrate is located in the through opening and is fixedly mounted on a surface that is of the heat sink and that faces the through opening, and each insulating substrate corresponds to the at least two limiting structures;
the at least one power semiconductor device is fixedly mounted on a surface that is of each insulating substrate and that is opposite to the heat sink, and each power semiconductor device is electrically connected to the circuit board;
the circuit board is fixedly mounted in the accommodation cavity, and is higher than the power semiconductor device in a height direction of the power converter; and
each limiting structure comprises a fitting part and a fixing part that cooperates with the fitting part, wherein the fitting part is disposed on the insulating substrate, and the fixing part is disposed on a surface on which the heat sink is in contact with the insulating substrate.

2. The power converter according to claim 1, wherein each fixing part is a fixing post, and a connection end of the fixing post is fixedly connected to the heat sink; and
each fitting part is a fitting hole that penetrates the insulating substrate, and the fitting hole is used for inserting the fixing post.

3. The power converter according to claim 1, wherein each fixing part is a fixing post, and a connection end of the fixing post is fixedly connected to the heat sink; and
each fitting part is a fitting notch that penetrates the insulating substrate, and the fitting notch is used for inserting the fixing post.

4. The power converter according to claim 1, wherein at least two fixing parts corresponding to each insulating substrate are fixing posts, and a connection end of each fixing post is fixedly connected to the heat sink;
at least one fitting part corresponding to each insulating substrate is a fitting hole for inserting the fixing post, and the at least one fitting part corresponding to each insulating substrate is a fitting notch for inserting the fixing post; and
a quantity of the fixing posts corresponding to each insulating substrate is equal to a sum of quantities of fitting holes and fitting notches that correspond to the insulating substrate.

5. The power converter according to claim 1, wherein each fixing part is a fixing hole located on the surface that is of the heat sink and that faces the through opening; and
each fitting part is a fitting protrusion for inserting into a corresponding fixing hole, and a connection end of the fitting protrusion is fixedly connected to the insulating substrate.

6. The power converter according to any one of claims 1 to 5, wherein at least two fitting parts on each insulating substrate are disposed at intervals along a circumferential direction of the insulating substrate; or
at least two fitting parts on each insulating substrate are located on a same side of the insulating substrate.

7. The power converter according to claim 1, wherein at least two fixing parts corresponding to each insulating substrate are disposed at intervals along a circumferential direction of the insulating substrate; and
each fixing part comprises a fixing structure that cooperates with a part of the insulating substrate, and a part that is of the insulating substrate and that cooperates with the fixing structure is used as the fitting part.

8. The power converter according to claim 7, wherein each fixing part comprises two fixing protrusions disposed at intervals, a connection end of the fixing protrusion is fixedly connected to the heat sink, and the two fixing protrusions and the surface of the heat sink jointly define a fixing notch; and
the part of the insulating substrate is inserted into the fixing notch and is in contact with the two fixing protrusions separately.

9. The power converter according to claim 7, wherein a side wall that is of each fixing part and that faces the insulating substrate defines a fixing groove; and
the part of the insulating substrate is inserted into the fixing groove and is in contact with an inner wall of the fixing groove.

10. The power converter according to any one of claims 1 to 9, wherein the insulating substrate is a ceramic substrate.

11. The power converter according to any one of claims 1 to 10, wherein the heat sink comprises a metal body part and a plurality of plate-shaped parts;
the metal body part is close to the through opening and is fixedly connected to the heat sink, and the insulating substrate is fixedly mounted on a surface that is of the metal body part and that faces the through opening; and
the plurality of plate-shaped parts are fixedly connected to the metal body part and are located on a surface that is of the metal body part and that is opposite to the insulating substrate, and the plurality of plate-shaped parts are disposed at intervals along a length direction of the metal body part.

12. The power converter according to any one of claims 1 to 11, wherein the power converter further comprises a pressing member, wherein a first end of the pressing member is fixedly connected to a surface end that is of the heat sink and that faces the through opening, a second end of the pressing member abuts against the power semiconductor device, and the pressing member is configured to fasten the power semiconductor device and the insulating substrate to the heat sink.

13. The power converter according to claim 12, wherein a third end of the pressing member is fixedly connected to the circuit board, and the circuit board is fastened to the housing by using the pressing member and the heat sink.
